# EUROPÄISCHE PATENTSCHRIFT

(11) **EP 2 239 850 B1**
(45) Veröffentlichungstag und Bekanntmachung des Hinweises auf die Patenterteilung: **04.06.2014**
(21) Anmeldenummer: 10158981.0
(22) Anmeldetag: 01.04.2010
(51) Int. Cl.: H03K 17/722, G06F 11/07, G05B 9/02, H04L 25/02, H03K 17/689, H03K 17/78, H03K 17/691, H03K 17/61

(54) **Steuereinrichtung und zugehöriges Steuerverfahren zur Steuerung einer elektrischen Einrichtung**
Control device and accompanying control method for controlling an electrical device
Dispositif de commande et procédé de commande correspondant destiné à la commande d'un dispositif électrique

(30) Priorität: 06.04.2009 DE 102009016485
(43) Veröffentlichungstag der Anmeldung: 13.10.2010
(73) Patentinhaber: Siemens Aktiengesellschaft, 80333 München (DE)
(72) Erfinder: Seitz, Johann, 92224 Amberg (DE); Hertz, Dirk, 92260 Fichtenhof (DE); Zitzler, Stefan, 92421 Schwandorf (DE)

(56) Entgegenhaltungen:
- EP-A2- 1 626 546
- DE-A1- 10 244 186
- US-A1- 2008 030 080

## Beschreibung

Die Erfindung betrifft eine Steuereinrichtung mit einem Steuereingang zur Eingabe eines Steuerbefehls, mit einer dem Steuereingang nachgeschalteten Eingangselektronik und mit einer Steuerelektronik, mit der eine elektrische Einrichtung mithilfe von Steuermitteln abhängig von dem Steuerbefehl steuerbar ist.

Derartige Steuereinrichtungen zur Steuerung finden z.B. bei elektronischen Schaltgeräten Anwendung, die üblicherweise über einen Steuereingang AUS und EIN geschaltet werden. In Verbindung mit Sicherheitsanforderungen wird dieser Steuereingang dabei aus einer sicheren Steuerung angesteuert. Liegt so ein Steuersignal im Zustand AUS am Steuereingang des elektronischen Schaltgeräts an, kann es bei Vorliegen eines einzelnen Fehlers im Ansteuerkreis des elektronischen Schaltgeräts dazu kommen, dass dieses fälschlicherweise einen EIN-Befehl erkennt und somit das Schaltgerät einschaltet. Es liegt somit ein sicherheitstechnisches Pro.B. ein Sanftanlaufgerät einen Motor einschaltet, obwohl ein AUS-Befehl anliegt. Selbst wenn das Sanftanlaufgerät den Schaltzustand der Leistungsschaltelemente überwacht, wird dieser Fehler nicht erkannt, da das Gerät fälschlicherweise einen EIN-Befehl anliegen sieht.

Dokumente US 2008/0030080 A1 und DE 102 44 186 A1 offenbaren jeweils eine Steuerschaltung enthaltend zwei Kanäle zur Übertragung eines Befehls zwischen zwei galvanisch isolierten Schaltungsteile der Steuerschaltung mit Erkennung und Auswertung von Gleichtaktstörungen.

Der Erfindung liegt daher die Aufgabe zu Grunde, eine Steuereinrichtung der oben genannten Art vorzuschlagen, die bei Auftreten von Fehlern die elektrische Einrichtung in den sicheren Zustand schaltet.

Die oben genannte Aufgabe wird mit den Merkmalen nach Anspruch 1 gelöst. Die oben genannte Steuereinrichtung ist dadurch gekennzeichnet, dass mittels mehrerer Schaltglieder in der Eingangselektronik mehrere Kanäle zur Weiterleitung des Steuerbefehls an die Steuerelektronik realisiert sind, dass Mittel vorgesehen sind, um zu erkennen, ob infolge eines fehlerhaften Zustands nicht auf allen Kanälen derselbe Steuerbefehl übertragen wird und dass einer der Kanäle ohne Zwischenschaltung der Steuerelektronik mit den Steuermitteln verbunden ist und über diesen Kanal auf die Steuermittel in vorbestimmter Weise einwirkbar ist.

Vorteilhafte Weiterbildungen der erfindungsgemäßen Kommunikationseinrichtung sind den Unteransprüchen 2 bis 9 zu entnehmen.

Besonders vorteilhaft ist es, wenn gemäß Anspruch 2 zwei Kanäle zur Weiterleitung des Steuerbefehls an die Steuerelektronik realisiert sind.

Eine vorteilhafte Weiterbildung besteht, wenn gemäß Anspruch 3 die Steuereinrichtung als Mikrocontroller ausgeführt ist.

Weiterhin ist es vorteilhaft, wenn gemäß Anspruch 4 die Schaltglieder als Optokoppler ausgeführt sind.

Von Vorteil ist es außerdem, wenn gemäß Anspruch 5 die Steuermittel über einen der Kanäle stromlos schaltbar sind.

Vorteilhafter Weise dient die elektrische Einrichtung gemäß Anspruch 6 zur Ein- und Ausschaltung von Stromkreisen.

Eine weitere vorteilhafte Ausführungsform besteht, wenn die Steuereinrichtung gemäß Anspruch 7 mit der elektrischen Einrichtung in einem Gerät integriert ist.

In einer besonders vorteilhaften Ausführungsform ist das Gerät nach Anspruch 8 als Schaltgerät ausgeführt.

Weiterhin ist es vorteilhaft, wenn nach Anspruch 9 eine Überwachungseinrichtung vorgesehen ist, durch die der Steuerelektronik signalisierbar ist, ob über den einen der Kanäle ohne Zwischenschaltung der Steuerelektronik eine Einwirkung auf die Steuermittel erfolgt.

Ein Ausführungsbeispiel der Erfindung wird im Folgenden anhand einer Zeichnung näher erläutert.

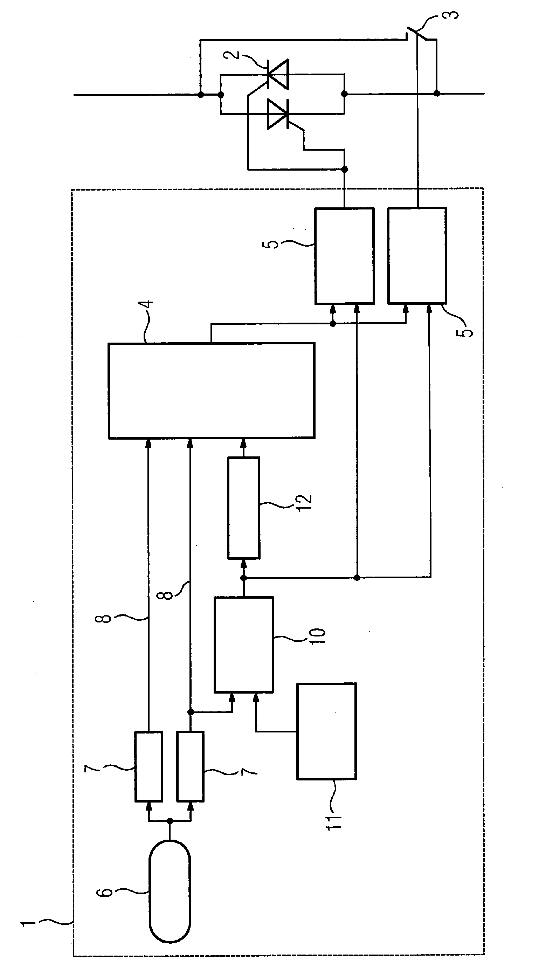

Die Figur zeigt ein Blockschaltbild einer erfindungsgemäßen Steuereinrichtung 1, mit der eine elektrische Einrichtung, z.B. ein elektronisches Schaltgerät, über elektronische Leistungsschaltelemente 2 und ein dazu parallel geschaltetes Überbrückungsrelais 3 ansteuerbar ist. Auf diese Weise kann die elektrische Einrichtung an eine elektrische Spannungsquelle zu- oder von dieser abgeschaltet werden. Das Herzstück der Steuereinrichtung 1 ist eine Steuerelektronik 4, hier ein Mikroprozessor, die über Steuermittel 5 mit den Leistungsschaltelementen 2 und dem Überbrückungsrelais 3 verbunden ist. Weiterhin ist ein Steuereingang 6 zur Eingabe eines Steuerbefehls, z.B. eines Steuerbefehls EIN oder AUS für das Schaltgerät vorgesehen, dem eine Eingangselektronik 7 nachgeschaltet ist. Die elektrische Einrichtung ist mithilfe der Steuermittel 5 abhängig von dem Steuerbefehl steuerbar. Die hinter dem Steuereingang 6 liegende Eingangselektronik 7 wird zweikanalig ausgeführt. Dies bedeutet z.B. bei einem potenzialgetrennten Steuereingang, dass mit Anliegen des Steuerbefehls zwei Schaltglieder, z.B. Optokoppler angesteuert und somit zwei Kanäle 8 zur Übertragung des Steuerbefehls an die Steuerelektronik 4 realisiert werden.

Die beiden an die Steuerelektronik 4 geführten Kanäle 8 werden hinsichtlich Plausibilität ausgewertet, so dass nur ein EIN-Befehl erkannt wird, wenn beide Kanäle 8 einen EIN-Befehl signalisieren. Tritt in einem der Kanäle 8 ein Fehler auf, ist der Zustand nicht plausibel und die Steuerelektronik 4 führt den sicheren Zustand AUS herbei.

Meist wird bei einer zweikanaligen Ausführung von Sicherheitszuständen eine Auswertung gefordert, bei der die Eingangselektronik 7 und die Steuerelektronik 4 unabhängig voneinander ausgewertet werden. Würde nämlich die Steuerelektronik 4 einen Fehler haben, könnte es wiederum dazu kommen, dass diese auf beiden Kanälen 8 einen EIN-Befehl erkennt und die elektrische Einrichtung fälschlicherweise einschaltet. Um dies zu verhindern, wird zusätzlich zur zweikanaligen Überwachung an der Steuerelektronik 4 einer der beiden Kanäle 8 dazu verwendet, auf die Steuermittel 5 so einzuwirken, dass auch bei fehlerhafter Reaktion der Steuerelektronik 4 die Leistungsschaltelemente 2, hier die Thyristoren nicht eingeschaltet werden. Zur Ansteuerung der Thyristoren sind eine Thyristoransteuerung sowie zugehörige Treiber als Steuermittel 5 vorgesehen. Die Überbrückungsrelais 3, mit denen die Leistungsschaltelemente 2 überbrückbar sind, werden mit den der Steuerelektronik 4 nachgeschalteten Bypassrelaisansteuerung und mit dieser zugeordneten Treibern als Steuermittel 5 angesteuert. Einer der beiden Kanäle 8 ist mit einer Sperreinrichtung 10 verbunden, durch die die Verbindung der Treiber mit einer Stromversorgungseinrichtung 11 unterbrochen wird. Auf diese Weise wird die Ansteuerung der elektrischen Einrichtung gesperrt und somit der sichere Zustand AUS herbeigeführt, wenn nur ein einziger Fehler auftritt.

Um zu erkennen, ob infolge eines fehlerhaften Zustands nicht auf allen Kanälen 8 derselbe Steuerbefehl übertragen wird, sind vorzugsweise in der Eingangselektronik 7 entsprechende Mittel vorgesehen.

Weiterhin ist eine Überwachungseinrichtung 12 vorgesehen, durch die der Steuerelektronik 4 signalisiert wird, ob über den einen der Kanäle 8 ohne Zwischenschaltung der Steuerelektronik 4 durch die Sperreinrichtung 10 eine Einwirkung auf die Steuermittel 5 erfolgt. Hierdurch kann zusätzlich die Funktion der Sperreinrichtung 10, d.h. deren Ausgangszustand überwacht werden.

Die Steuereinrichtung 1 kann mit der elektrischen Einrichtung in einem Gerät, z.B. einem Schaltgerät, integriert sein.

Mit der erfindungsgemäßen Steuereinrichtung 1 kann ausgeschlossen werden, dass bei Auftreten eines Fehlers innerhalb der kompletten Steuereinrichtung 1 die elektrische Einrichtung unbeabsichtigt eingeschaltet werden kann.

Bei dem zur Steuereinrichtung 1 zugehörigen Steuerverfahren wird eine elektrische Einrichtung mithilfe der Steuermittel 5 abhängig von dem Steuerbefehl gesteuert, der der Steuerelektronik 4 über einen Steuereingang zugeführt wird. Weiterhin weist das Steuerverfahren folgende Schritte auf:
- In der dem Steuereingang nachgeschalteten Eingangselektronik 7 wird der Steuerbefehl auf mehrere Kanäle 8 geschaltet und über diese an die Steuerelektronik 4 übertragen,
- durch einen der Kanäle 8 wird in vorbestimmter Weise auf die Steuermittel 5 ohne Zwischenschaltung der Steuerelektronik 4 eingewirkt.

Vorzugsweise wird gemäß der in der Figur dargestellten Steuereinrichtung 1 der Steuerbefehl auf zwei Kanäle 8 geschaltet und über diese an die Steuerelektronik 4 übertragen. Die Steuermittel 5 können über einen der Kanäle 8 stromlos geschaltet.

Die elektrische Einrichtung dient z.B. zur Ein- und Ausschaltung von Stromkreisen und weist einen EIN- und einen AUS-Zustand auf.

## Patentansprüche

1. Steuereinrichtung (1) mit einem Steuereingang zur Eingabe eines Steuerbefehls, mit einer dem Steuereingang nachgeschalteten Eingangselektronik (7), mit einer Steuerelektronik (4) und mit Steuermitteln (5), wobei die Steuermittel (5) zur Ansteuerung einer elektrischen Einrichtung über elektronische Leistungsschaltelemente (2) dienen und Hilfsantrag 2 durch die Steuerelektronik (4) abhängig von dem Steuerbefehl steuerbar sind, **dadurch gekennzeichnet, dass** mittels mehrerer Schaltglieder in der Eingangselektronik (7) mehrere Kanäle (8) zur Weiterleitung des Steuerbefehls an die Steuerelektronik (4) realisiert sind, dass Mittel vorgesehen sind, um zu erkennen, ob in Folge eines fehlerhaften Zustands nicht auf allen Kanälen (8) derselbe Steuerbefehl übertragen wird und dass einer der Kanäle (8) ohne Zwischenschaltung der Steuerelektronik (4) mit den Steuermitteln (5) verbunden ist und über diesen Kanal (8) auf die Steuermittel (5) in vorbestimmter Weise derart einwirkbar ist, dass bei fehlerhafter Reaktion der Steuerelektronik (4) die Leistungsschaltelemente (2) nicht eingeschaltet werden.

2. Steuereinrichtung nach Anspruch 1, **dadurch gekennzeichnet, dass** zwei Kanäle (8) zur Weiterleitung des Steuerbefehls an die Steuerelektronik (4) realisiert sind.

3. Steuereinrichtung nach Anspruch 1 oder 2, **dadurch gekennzeichnet, dass** die Steuereinrichtung (1) als Mikrocontroller ausgeführt ist.

4. Steuereinrichtung nach einem der vorangehenden Ansprüche, **dadurch gekennzeichnet, dass** die Schaltglieder als Optokoppler ausgeführt sind.

5. Steuereinrichtung nach Anspruch 4, **dadurch gekennzeichnet, dass** die Steuermittel (5) über einen der Kanäle (8) stromlos schaltbar sind.

6. Steuereinrichtung nach einem der vorangehenden Ansprüche, **dadurch gekennzeichnet, dass** die elektrische Einrichtung zur Ein- und Ausschaltung von Stromkreisen dient, d.h. einen EIN- und einen AUS-Zustand aufweist.

7. Steuereinrichtung nach einem der vorangehenden Ansprüche, **dadurch gekennzeichnet, dass** sie mit der elektrischen Einrichtung in einem Gerät integriert ist.

8. Steuereinrichtung nach Anspruch 7, **dadurch gekennzeichnet, dass** das Gerät als Schaltgerät ausgeführt ist.

9. Steuereinrichtung nach einem der vorangehenden Ansprüche, **dadurch gekennzeichnet, dass** eine Überwachungseinrichtung (12) vorgesehen ist, durch die der Steuerelektronik (4) signalisierbar ist, ob über den einen der Kanäle (8) ohne Zwischenschaltung der Steuerelektronik (4) eine Einwirkung auf die Steuermittel (5) erfolgt.

## Claims

1. Control device (1) having a control input for entering a control command, having an input electronics system (7) arranged downstream of the control input, having a control electronics system (4) and having control means (5), wherein the control means (5) are used to actuate an electrical device by way of electronic power switch elements (2) and can be controlled by the control electronics system (4) as a function of the control command,
**characterised in that**
by means of a number of switching elements in the input electronics system (7), a number of channels (8) for forwarding the control command to the control electronics system (4) are realised such that means are provided in order to identify whether, as a result of a faulty state, the same control command is not transmitted on all channels (8) and that one of the channels (8) is connected to the control means (5) without interconnecting the control electronics system (4) and can affect the control means (5) in a predetermined manner by way of this channel (8) such that with a faulty reaction by the control electronics system (4), the power switch elements (2) are not switched on.

2. Control device according to claim 1, **characterised in that** two channels (8) are realised for forwarding the control command to the control electronics system (4).

3. Control device according to claim 1 or 2, **characterised in that** the control device (1) is embodied as a microcontroller.

4. Control device according to one of the preceding claims, **characterised in that** the switching elements are embodied as optocouplers.

5. Control device according to claim 4, **characterised in that** the control means (5) can be de-energised by way of one of the channels (8).

6. Control device according to one of the preceding claims, **characterized in that** the electric device is used to switch electric circuits on and off, i.e. it has an ON and OFF state.

7. Control device according to one of the preceding claims, **characterised in that** it is integrated in a device with the electric device.

8. Control device according to claim 7, **characterised in that** the device is embodied as a switching device.

9. Control device according to one of the preceding claims, **characterised in that** a monitoring device (12) is provided, by means of which the control electronics system (4) can be signalled to determine whether by way of the one channel (8) the control means (5) are affected without interconnection of the control electronics system (4).

## Revendications

1. Dispositif ( 1 ) de commande ayant une entrée de commande pour l'entrée d'une instruction de commande, une électronique ( 7 ) d'entrée, une électronique ( 4 ) de commande et des moyens ( 5 ) de commande, les moyens ( 5 ) de commande servant à commander un dispositif électrique par des éléments ( 2 ) électroniques de commutation de puissance et pouvant être commandés par l'électronique ( 4 ) de commande en fonction de l'instruction de commande, **caractérisé en ce qu'**à l'aide de plusieurs éléments de commutation, sont réalisés dans l'électronique ( 7 ) d'entrée plusieurs canaux pour l'acheminement de l'instruction de commande à l'électronique ( 4 ) de commande, **en ce qu'**il est prévu des moyens pour reconnaître si, à la suite d'un état défectueux, la même instruction de commande n'a pas été transmise à tous les canaux ( 8 ) et **en ce que** l'un des canaux ( 8 ) est, sans interposition de l'électronique ( 4 ) de commande, relié aux moyens ( 5 ) de commande et par ce canal ( 8 ) il peut être agi sur les moyens ( 5 ) de commande d'une façon déterminée à l'avance, de manière à ce qu'en cas de réaction défectueuse de l'électronique ( 4°) de commande, les éléments ( 2 ) de commutation de puissance ne soient pas fermés.

2. Dispositif de commande suivant la revendication 1, **caractérisé en ce que** deux canaux ( 8 ) sont réalisés pour l'acheminement de l'instruction de commande à l'électronique ( 4 ) de commande.

3. Dispositif de commande suivant la revendication 1 ou 2, caractérisé en ce le dispositif ( 1 ) de commande est réalisé en micro-unité de commande.

4. Dispositif de commande suivant une des revendications précédentes, **caractérisé en ce que** les éléments de commutation sont réalisés sous la forme d'optocoupleurs.

5. Dispositif de commande suivant la revendication 4, **caractérisé en ce que** les moyens ( 5 ) de commande peuvent être mis en circuit sans courant par l'un des canaux ( 8 ).

6. Dispositif de commande suivant l'une des revendications précédentes, **caractérisé en ce que** le dispositif électrique sert à la mise en circuit et hors circuit de circuits, c'est-à-dire en un état fermé et un état ouvert.

7. Dispositif de commande suivant l'une des revendications précédentes, **caractérisé en ce qu'**il est intégré avec le dispositif électrique dans un appareil.

8. Dispositif de commande suivant la revendication 7, **caractérisé en ce que** l'appareil est réalisé sous la forme d'un appareil de commutation.

9. Dispositif de commande suivant l'une des revendications précédentes, **caractérisé en ce qu'**il est prévu un dispositif ( 12 ) de contrôle, par lequel il peut être signalé à l'électronique ( 4 ) de commande qu'il s'effectue par l'un des canaux ( 8 ), sans interposition de l'électronique ( 4 ) de commande, une action sur les moyens de commande.
